# EUROPEAN PATENT APPLICATION

(11) **EP 2 713 174 A1**
(43) Date of publication of application: **02.04.2014**
(21) Application number: 12867683.0
(22) Date of filing: 07.06.2012
(51) Int. Cl.: G01R 31/36, G01R 19/165

(54) **METHOD AND APPARATUS FOR DIAGNOSING FAULTS IN A BATTERY PACK, AND POWER RELAY ASSEMBLY USING SAME**

(30) Priority: 02.02.2012 KR 20120010668
(71) Applicant: LG Chem, Ltd., Seoul 150-721 (KR)
(72) Inventor: BAEK, Seongmun, Daejeon 305-380 (KR)
(74) Representative: Cabinet Plasseraud
(86) International application number: PCT/KR2012/004464
(87) International publication number: WO 2013/115437

(57) **Abstract**

There are disclosed a method and apparatus for diagnosing faults in a battery pack and a power relay assembly using the same. An apparatus for diagnosing faults in a battery pack including a plurality of cells includes a pack voltage measurement unit for measuring a voltage of the battery pack, a cell voltage measurement unit for measuring a plurality of cell voltage for the plurality of cells, and a controller for determining whether there are faults in the battery pack based on the voltage of the battery pack and the plurality of cell voltages. A battery pack and a load connected to the battery pack can be protected by diagnosing whether there are faults in the battery.

## Description

### [Technical Field]

This application claims the benefit of priority of Korean Patent Application No. 10-2012-0010668 filed on February 2, 2012, all of which is incorporated by reference in its entirety herein.

The present invention relates to a method and apparatus for diagnosing faults in a battery pack and, more particularly, to a method and apparatus for protecting a battery pack by diagnosing faults in the battery pack and a power relay assembly using the same.

### [Background]

As the use of portable electric products, such as a notebook, a video camera, and a portable phone, becomes active, the importance of a secondary cell chiefly used as the driving power sources of the portable electric products is increasing.

Furthermore, as there is an increasing interest in an environmental problem, active research is being carried out on a hybrid vehicle and an electric vehicle. Consumers respond to the hybrid vehicle or the electric vehicle rather better than a vehicle using only an engine in that the hybrid vehicle or the electric vehicle has excellent fuel efficiency and reduced pollutants because the hybrid vehicle or the electric vehicle is driven by energy charged into and discharged from a battery pack. For this reason, lots of interests and researches are focused on a battery, that is, a core part of the hybrid vehicle or the electric vehicle.

As products using a battery is increasing as described above, a problem related to the safety of the battery becomes important. Furthermore, in a hybrid vehicle or an electric vehicle, it is more important to safely maintain a battery than common portable electric products in that a plurality of secondary battery cells forms a single pack and a plurality of the packs forms a single high-capacity battery.

In particular, resistance is generated because of the aging of secondary battery cells forming a battery or the loosening phenomenon of bus bars for connection between the secondary battery cells. If this resistance is increased, heat is generated in the battery, which may become a factor to damage circuits within the battery or the battery itself. Furthermore, this resistance may lead to the explosion of the battery, which may become a factor to generate a fire.

Accordingly, there is a need for a method of diagnosing and protecting the internal state of a battery. Furthermore, there is a need for a method of protecting a battery and an external system connected to the battery by releasing an electrical connection with the external system when any fault is diagnosed at the battery.

### [Detailed Description]

### [Technical Problem]

The present invention provides a method and apparatus for diagnosing whether there are faults in a battery pack by measuring voltage of a battery cell and voltage of the battery pack.

The present invention provides a method and apparatus for protecting a battery pack and a load by releasing an electrical connection between the battery pack and the load according to whether there are faults in the battery pack.

### [Technical Solution]

In an embodiment of the present invention, an apparatus for diagnosing faults in a battery pack is provided. The battery pack includes a plurality of cells. The apparatus includes a pack voltage measurement unit configured to measure a voltage of the battery pack, a cell voltage measurement unit configured to measure a plurality of cell voltages for the plurality of cells, and a controller configured to determine whether there are faults in the battery pack based on the voltage of the battery pack and the plurality of cell voltages.

The controller may be configured to determine a difference between the voltage of the battery pack and a sum of the plurality of cell voltages. The controller may be configured to determine that there is the fault at the battery pack when the difference is greater than or equal to a predetermined threshold.

The controller may be configured to release an electrical connection between the battery pack and a load when it is determined that there is the fault. And, the controller may be configured to inform a user whether there is the fault at the battery pack.

In another embodiment of the present invention, a method for diagnosing faults in a battery pack is provided. The battery pack includes a plurality of cells. The method includes measuring a voltage of the battery pack, measuring a plurality of cell voltages for the plurality of cells, and determining whether there are faults in the battery pack based on the voltage of the battery pack and the plurality of cell voltages.

The step of determining whether there is the fault may include determining a difference between the voltage of the battery pack and a sum of the plurality of cell voltages, and determining whether there is the fault at the battery pack by comparing the difference with a predetermined threshold.

It can be determined that there is the fault at the battery pack when the difference is greater than or equal to the predetermined threshold.

The method may further include releasing an electrical connection between the battery pack and a load when it is determined that there is the fault.

The electrical connection may be released by turning off a switch included in a power relay assembly. The power relay assembly may be connected to the battery pack and may be configured to transfer power to the load.

The method may further include providing a user with whether there is the fault at the battery pack.

In still another embodiment of the present invention, a power relay assembly for controlling an electrical connection between a load and a battery pack is provided. The battery pack includes a plurality of cells. The power relay assembly includes a switch configured to control the electrical connection between the battery pack and the load, a pack voltage measurement unit configured to measure a voltage of the battery pack, a cell voltage measurement unit configured to measure a plurality of cell voltages for the plurality of cells, and a controller configured to determine whether there are faults in the battery pack based on the voltage of the battery pack and the plurality of cell voltages. The controller is configure to determine a difference between the voltage of the battery pack and a sum of the plurality of cell voltages and determine that there is the fault at the battery pack when the difference is greater than or equal to a predetermined threshold.

The controller may be configured to turn off the switch when it is determined that there is the fault at the battery pack. The controller may be configured to inform a user whether there is the fault at the battery pack.

### [Advantageous Effects]

Faults in a battery pack can be diagnosed. The battery pack and its load can be protected.

### [Description of Drawings]

FIG. 1 is a diagram schematically showing an apparatus for diagnosing faults in a battery pack according to an embodiment of the present invention.
FIG. 2 is a flowchart illustrating a method of diagnosing whether there are faults in a battery pack according to an embodiment of the present invention.

### [Mode for Invention]

Hereinafter, some embodiments of the present invention are described in detail with reference to the accompanying drawings in order for those skilled in the art to be able to readily implement the invention. Furthermore, the present invention is not limited to the following embodiments and may be modified in various ways within the scope of the technical spirit of the present invention.

Elements described in this specification may include additional elements other than elements to be described later if necessary and a detailed description of parts not directly related to the present invention or redundant contents is omitted. Furthermore, the deployment of the elements described in this specification may be changed if necessary, one element may be included in the other element, and one element may be subdivided into two or more elements.

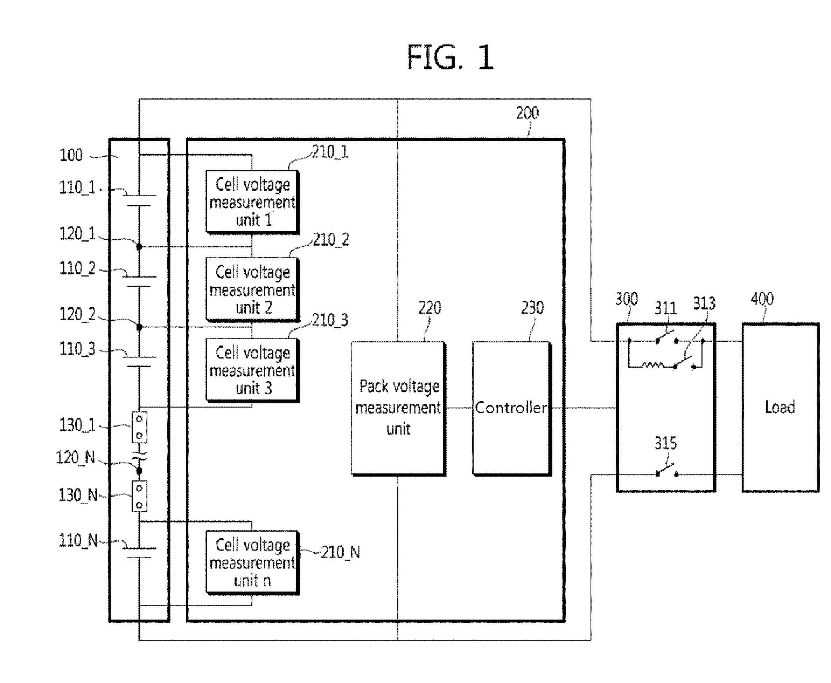

FIG. 1 is a diagram schematically showing an apparatus for diagnosing faults in a battery pack according to an embodiment of the present invention.

Referring to FIG. 1, the apparatus for diagnosing faults in a battery pack 200 (hereinafter referred to as 'the fault diagnosing apparatus 200') according to the embodiment of the present invention is connected to a battery pack 100 and configured to diagnose whether there are faults in the battery pack 100. Furthermore, the fault diagnosing apparatus 200 is configured to control so that power is supplied to a load 400 through a power relay assembly 300 or the supply of power to the load 400 is blocked according to whether there are faults in the battery pack 100.

The battery pack 100 includes a plurality of battery cells 110_1 to 110_N which may be coupled in series and/or in parallel. The serial connection and/or the parallel connection between the battery cells 110_1 to 110_N are connected by welding parts 120_1 to 120_N or bus bars 130_1 to 130_N. A plurality of the battery packs 100 may be included in order to form a high-output or high-capacity battery.

The fault diagnosing apparatus 200 for diagnosing the state of the battery pack 100 includes cell voltage measurement units 210_1 to 210_N, a pack voltage measurement unit 220, and a controller 230. The construction of each of the elements of the fault diagnosing apparatus 200 is described in detail below.

The cell voltage measurement units 210_1 to 210_N measure voltages of the battery cells 110_1 to 110_N. For example, the cell voltage measurement unit 1 210_1 may have sensing lines connected to both terminals of the battery cell 110_1 and measure voltage of the battery cell 110_1. Furthermore, the cell voltage measurement unit 2 210_2 may have sensing lines connected to both terminals of the battery cell 110_2 and measure voltage of the battery cell 110_2.

Likewise, the cell voltage measurement units 210_1 to 210_N measure the respective voltages of the battery cells 110_1 to 110_N included in the battery pack 100. The measured voltages of the battery cells 110_1 to 110_N are transferred to the controller 230.

The pack voltage measurement unit 220 measures a voltage of the battery pack 100. That is, the pack voltage measurement unit 220 has sensing lines connected to both terminals of the battery pack 100 and measures a voltage of the battery pack 100. The measured voltage of the battery pack 100 is transferred to the controller 230.

Here, the cell voltage measurement units 210_1 to 210_N and the pack voltage measurement unit 220 sense voltages of the respective battery cells and a voltage of the battery pack, respectively, and output the sensed voltages in the form of voltage signals. The cell voltage measurement units 210_1 to 210_N and the pack voltage measurement unit 220 may be implemented using common circuits. Accordingly, there is an advantage in that an additional circuit for measuring a voltage needs not to be installed.

The controller 230 determines whether there are faults in the battery pack 100 based on voltages of the battery cells 110_1 to 110_N measured by the respective cell voltage measurement units 210_1 to 210_N and the voltage of the battery pack 100 measured by the pack voltage measurement unit 220. Furthermore, the controller 230 performs control so that power is supplied to the load 400 through the power relay assembly 300 or the supply of power to the load 400 is blocked depending on the state of the battery pack 100. As an alternative, the controller 230 may perform control so that a user is informed of the state of the battery pack 100.

More particularly, the controller 230 may determine whether there are faults in the battery pack 100 by comparing the voltage of the battery pack 100 with the sum of the voltages of the battery cells 110_1 to 110_N.

The voltage of the battery pack 100 must be identical with the sum of the voltages of the battery cells 110_1 to 110_N, but a voltage drop phenomenon is occured owing to resistance of the welding parts 120_1 to 120_N or the bus bars 130_1 to 130_N for a connection between the battery cells 110_1 to 110_N. For example, the voltage across the battery pack 100 may be lower than the sum of the voltages of the battery cells 110_1 to 110_N because of a phenomenon in which the welding parts 120_1 to 120_N or the bus bars 130_1 to 130_N become loose.

That is, the controller 230 may calculate a difference between the voltage of the battery pack 100 and the sum of the voltages of the battery cells 110_1 to 110_N and determine whether there are faults in the battery pack 100 by comparing the difference with a predetermined threshold.

For example, if the calculated difference is greater than or equal to the predetermined threshold, the controller 230 may determine that there are faults in the battery pack 100. In contrast, if the calculated difference is less than the predetermined threshold, the controller 230 may determine that there are not faults in the battery pack 100.

Here, if it is determined that there are faults in the battery pack 100, the controller 230 performs control so that an electrical connection between the battery pack 100 and the load 400 is released.

More particularly, the load 400 is an element that consumes power and is electrically connected to the battery pack 100. In accordance with an embodiment of the present invention, the load 400 is electrically connected to the battery pack 100 through the power relay assembly 300.

The power relay assembly 300 is a device for controlling an electrical connection between the battery pack 100 and the load 400, and it may include one or more switches 311, 313, and 315. The switches 311, 313, and 315 may be coupled in parallel.

That is, if it is determined that there are faults in the battery pack 100, the controller 230 may block power supplied to the load 400 by performing control so that the switches 311, 313, and 315 of the power relay assembly 300 are turned off.

In contrast, if it is determined that there are not faults in the battery pack 100, the controller 230 performs control so that power is supplied to the load 400. That is, the controller 230 performs control so that the switches 311, 313, and 315 of the power relay assembly 300 are turned on.

As an alternative, the controller 230 may provide a user with results regarding whether there are faults in the battery pack 100. For example, if there are faults in the battery pack 100, the controller 230 may give warning to a user through an output screen (not shown) or a sensor (not shown).

The fault diagnosing apparatus 200 according to the embodiment of FIG. 1 has been illustrated as being an independent device, but may be included in the power relay assembly 300 and configured to diagnose faults of the battery pack 100. As an alternative, the fault diagnosing apparatus 200 may be included in a battery management system within an electric vehicle or a hybrid electric vehicle and configured to perform a function of diagnosing faults in a battery pack.

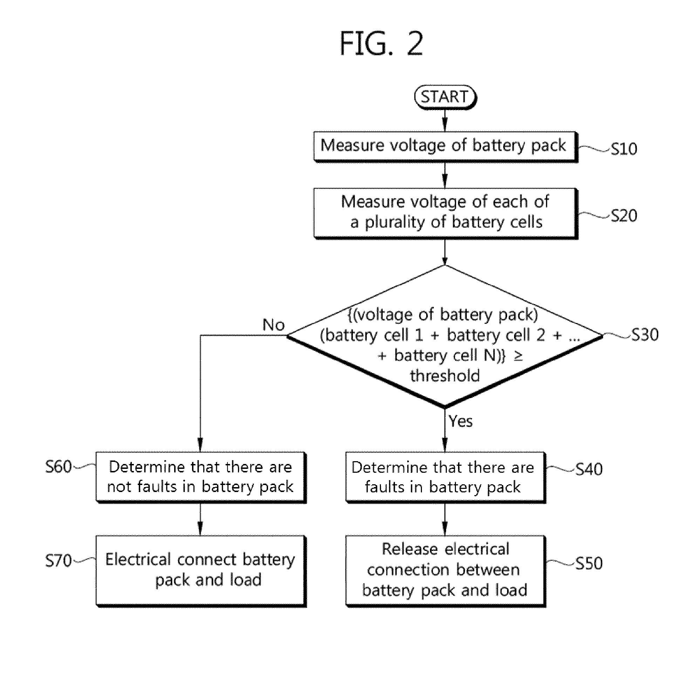

FIG. 2 is a flowchart illustrating a method of diagnosing whether there are faults in a battery according to an embodiment of the present invention. This method may be performed by the fault diagnosing apparatus 200 of FIG. 1.

Referring to FIG. 2, a voltage of a battery pack is measured at step S10. For example, sensing lines may be coupled to both terminals of the battery pack 100, and a voltage signal may be measured by sensing the voltage of the battery pack.

Here, the battery pack may include a plurality of battery cells, as described with reference to FIG. 1, and the plurality of battery cells may be coupled in series and/or in parallel. Here, a connection between the battery cells, that is, a connection between one battery cell and the other battery cell, may be connected by a welding part or a bus bar.

Next, a voltage of each of the plurality of battery cells included in the battery pack is measured at step S20. For example, sensing lines may be connected to both terminals of each of the battery cells included in the battery pack, and a voltage signal may be measured by sensing the voltage of each battery cell.

Next, whether there are faults in the battery pack is determined by comparing the voltage of the battery pack with a sum of the voltages of the plurality of battery cells at step S30.

As described above, the voltage of the battery pack must be identical with the sum of the voltages of the plurality of battery cells, but the voltage of the battery pack drops owing to resistance, such as a phenomenon in which the welding parts or the bus bars for a connection between the battery cells become loose. If the voltage of the battery pack has greatly dropped owing to resistance within the battery pack, it may be determined that there are faults in the battery pack.

That is, whether there are faults in the battery pack may be determined by comparing a difference between the voltage of the battery pack and the sum of the voltages of the plurality of battery cells with a predetermined threshold.

If, as a result of the comparison, the difference is greater than or equal to the predetermined threshold, it may be determined that there are faults in the battery pack at step S40, and an electrical connection between the battery pack and a load is released at step S50.

For example, if there are faults in the battery pack, an electrical connection between the battery pack and the load may be released by controlling a power relay assembly connected to the battery pack and configured to transfer power to the load. That is, the power supplied to the load may be blocked by turning off switches included in the power relay assembly that controls an electrical connection between the battery pack and the load.

In contrast, if, as a result of the comparison, the difference is less than the predetermined threshold, it is determined that there are not faults in the battery pack at step S60, and control is performed so that the battery pack and the load are electrically coupled at step S70. For example, the power may be supplied to the load by turning on switches included in the power relay assembly that controls an electrical connection between the battery pack and the load so that the switches are connected to the battery pack.

Furthermore, results regarding whether there are faults in the battery pack may be provided to a user. For example, the state of the battery pack may be provided to a user through an output screen or a sensor.

In the fault diagnosing apparatus and method described above according to the present invention, the degree of an increase in resistance (e.g., the loosening of the welding parts or the bus bars for a connection between the battery cells) within the battery pack may be detected by measuring a voltage of the battery pack and voltages of the battery cells included in the battery pack. Accordingly, problems, such as that the lifespan of a battery pack is reduced by heat generated in the battery pack and that a fire is generated in the battery pack, can be solved. Furthermore, when abnormal resistance within a battery pack is detected, an electrical connection between the battery pack and a load is released. Accordingly, the load and a battery system can be protected.

Furthermore, whether there are faults in a battery pack can be diagnosed, and thus a battery system and a load connected to the battery system can be protected.

The steps of the flowchart according to the present invention may be performed in order different from that described above or may be performed at the same time. Furthermore, those skilled in the art will understand that the steps shown in the flowchart are not exclusive and they may include other steps or one or more steps of the flowchart may be deleted without affecting the scope of the present invention.

While some exemplary embodiments of the present invention have been described with reference to the accompanying drawings, those skilled in the art may change and modify the present invention in various ways without departing from the essential characteristic of the present invention. Accordingly, the disclosed embodiments should not be construed to limit the technical spirit of the present invention, but should be construed to illustrate the technical spirit of the present invention. The scope of the technical spirit of the present invention is not limited by the embodiments, and the scope of the present invention should be interpreted based on the following appended claims. Accordingly, the present invention should be construed to cover all modifications or variations induced from the meaning and scope of the appended claims and their equivalents.

## Claims

1. An apparatus for diagnosing faults in a battery pack, the battery pack including a plurality of cells, the apparatus comprising:
a pack voltage measurement unit configured to measure a voltage of the battery pack;
a cell voltage measurement unit configured to measure a plurality of cell voltages for the plurality of cells; and
a controller configured to determine whether there are faults in the battery pack based on the voltage of the battery pack and the plurality of cell voltages.

2. The apparatus of claim 1, wherein the controller is configured to determine a difference between the voltage of the battery pack and a sum of the plurality of cell voltages.

3. The apparatus of claim 2, wherein the controller is configured to determine that there is the fault at the battery pack when the difference is greater than or equal to a predetermined threshold.

4. The apparatus of claim 1, wherein the controller is configured to release an electrical connection between the battery pack and a load when it is determined that there is the fault.

5. The apparatus of claim 1, wherein the controller is configured to inform a user whether there is the fault at the battery pack.

6. A method for diagnosing faults in a battery pack, the battery pack including a plurality of cells, the method comprising:
measuring a voltage of the battery pack;
measuring a plurality of cell voltages for the plurality of cells; and
determining whether there are faults in the battery pack based on the voltage of the battery pack and the plurality of cell voltages.

7. The method of claim 6, wherein the step of determining whether there is the fault comprises:
determining a difference between the voltage of the battery pack and a sum of the plurality of cell voltages; and
determining whether there is the fault at the battery pack by comparing the difference with a predetermined threshold.

8. The method of claim 7, wherein it is determined that there is the fault at the battery pack when the difference is greater than or equal to the predetermined threshold.

9. The method of claim 6, further comprising:
releasing an electrical connection between the battery pack and a load when it is determined that there is the fault.

10. The method of claim 9, wherein the electrical connection is released by turning off a switch included in a power relay assembly, and
wherein the power relay assembly is connected to the battery pack and is configured to transfer power to the load.

11. The method of claim 6, further comprising:
providing a user with whether there is the fault at the battery pack.

12. A power relay assembly for controlling an electrical connection between a load and a battery pack, the battery pack including a plurality of cells, the power relay assembly comprising:
a switch configured to control the electrical connection between the battery pack and the load;
a pack voltage measurement unit configured to measure a voltage of the battery pack;
a cell voltage measurement unit configured to measure a plurality of cell voltages for the plurality of cells; and
a controller configured to determine whether there are faults in the battery pack based on the voltage of the battery pack and the plurality of cell voltages,
wherein the controller is configure to determine a difference between the voltage of the battery pack and a sum of the plurality of cell voltages and determine that there is the fault at the battery pack when the difference is greater than or equal to a predetermined threshold.

13. The power relay assembly of claim 12, wherein the controller is configured to turn off the switch when it is determined that there is the fault at the battery pack.

14. The power relay assembly of claim 12, wherein the controller is configured to inform a user whether there is the fault at the battery pack.
